# EUROPÄISCHE PATENTSCHRIFT

(11) **EP 2 265 102 B1**
(45) Veröffentlichungstag und Bekanntmachung des Hinweises auf die Patenterteilung: **25.06.2014**
(21) Anmeldenummer: 09014449.4
(22) Anmeldetag: 19.11.2009
(51) Int. Cl.: H05K 5/06, H05K 3/28

(54) **Sensoraufbau ohne Gehäuse**
Sensor device without housing
Structure de capteur sans boîtier

(30) Priorität: 19.06.2009 DE 102009029939
(43) Veröffentlichungstag der Anmeldung: 22.12.2010
(73) Patentinhaber: Baumer Innotec AG, 8500 Frauenfeld (CH)
(72) Erfinder: Wehrle, Wolfgang, 78467 Konstanz (DE); Jürgens, Alexander, 8500 Frauenfeld (CH)
(74) Vertreter: Strauss, Steffen

(56) Entgegenhaltungen:
- DE-A1-102006 018 457
- US-A- 4 911 519
- US-A- 5 113 466
- US-A- 5 123 066
- US-A1- 2005 281 009
- US-B1- 7 296 345

## Beschreibung

Die vorliegende Erfindung betrifft ein Verfahren zur Fertigung von elektronischen Sensoren, insbesondere zur Kapselung (im englischen Packaging) von Sensoren, sowie die mit dem Verfahren hergestellten Sensoren.

Elektronische Sensoren dienen allgemein zum quantitativen und/oder qualitativen Erfassen physikalischer Messgrößen aus ihrer Umgebung, wobei die erfassten Messgrößen zur Weiterverarbeitung in elektrische Signale umgeformt und übertragen werden. Grundsätzlich kann zwischen aktiven und passiven Sensoren unterschieden werden, wobei die aktiven Sensoren neben einem eigentlichen Messgrößenaufnehmer eine zusätzliche Primärelektronik umfassen und mit einer äußeren Hilfsenergie gespeist werden. Als Beispiel für derartige elektronische Sensoren sind induktive bzw. kapazitive Näherungsschalter, Magnetsensoren, Lichttaster, Lichtschranken, Lichtwellenleitersensoren, induktive Abstandssensoren, Triangulationsabstandssensoren, und phasenmesssender optischer Abstandssensoren in nicht abschließender Aufzählung zu nennen.

Der technologische Aufbau solcher Sensoren umfasst in der Regel ein robustes Gehäuse, das einen Messgrößenaufnehmer und eine entsprechende Elektronik auf einer Leiterplatte beinhaltet, wobei eine Kontaktierung der Sensorelektronik durch das Gehäuse nach außen geführt ist. Als mögliche Sensorbauformen haben sich, je nach gewünschter technischer Anwendung, Sensoren sowohl mit zylindrischen als auch mit eckigen Gehäusetypen am Markt etabliert. Die Gehäuse sind in der Regel aus Metall oder Kunststoff vorgefertigt, so dass der Messgrößenaufnehmer, die Sensorelektronik sowie die Kontaktierung beispielsweise in Form eines Kabels oder eines Steckkontakts in diese eingebaut werden können. In der Regel werden die im Gehäuse eingebauten Bauelemente eines Sensors zum Schutz vor Umgebungseinflüssen und zur mechanischen Stabilisierung des Sensoraufbaus in Vergussmassen eingegossen.

Ein jeweiliger Messgrößenaufnehmer kann sowohl aus einem einzelnen elektronischen, elektromechanischen oder optoelektronischen Bauelement, als auch aus einer vorgefertigten Gruppe von elektronischen, mechanischen und/oder optischen Komponenten bestehen.

Unter einer eckigen Sensorbauform wird im Rahmen der vorliegenden Erfindung ein Sensor mit einem im Allgemeinen polyederförmigen Gehäusekörper verstanden, der in der Regel im Wesentlichen die Form eines Quaders oder mehrerer ineinander verschachtelter Quader aufweist. Entsprechende eckige Sensorbauformen eignen sich besonders Vorteilhaft für die Montage in T-Nuten von Profilsystemen, die beispielsweise im Bereich des Sondermaschinenbaus weit verbreitet sind. Grundsätzlich können eckige Sensoren auch an beliebigen tragenden Elementen von Anlagen bzw. Maschinen befestigt werden.

Nachteilig gegenüber den zylindrischen Sensorbauformen sind die aufwendig gefrästen Metall- oder Kunststoffgehäuse der eckigen Sensoren, deren Herstellung vergleichsweise kostenaufwendig ist. Alternativ können die Gehäuse eckiger Sensoren aus Zinkdruckguss hergestellt werden, wobei das Problem der teuren Gehäuse auf hohe Initialaufwendungen für die Gussform verlagert wird. Bezogen auf kleine Stückzahlen bleibt das Problem hoher Herstellkosten und eingeschränkter Flexibilität bei eckigen Sensorbauformen bestehen.

Ein weiterer Nachteil einer eckiger Sensorbauform ist, dass diese Sensoren an einer ebenen Fläche eines Maschinen- oder Anlagengehäuses mit wenigstens zwei Befestigungsschrauben montiert werden müssen, was ein gegenüber zylindrischen Sensoren einen erhöhten Aufwand darstellt.

Eine weitere Bauform stellt ein sogenannter "gehäuseloser" Sensor dar, dessen elektronische Bauelemente im Fertigungsprozess zunächst mechanisch zueinander bewegbar kontaktiert werden, bevor sie in eine Spritzgussform eingelegt und dort mittels Fixierelemente in einer festen, vorbestimmten Lage gehalten werden. Die Bauelemente werden anschließend mit einer Kunststoffmasse vollständig umspritzt, wobei aus der Kunststoffmasse ein Formkörper gebildet wird, dessen Außenabmessungen den Innenabmessungen der Spritzgussform entspricht.

Nachteilig bei diesen Verfahren ist, dass die einzelnen Bauelemente wie der Messgrößenaufnehmer eines Sensors, eine Leiterplatte mit der Primärelektronik und einer Kontaktierung einzeln in der Spritzgussform aufwendig und präzise platziert und fixiert werden müssen. Des Weiteren müssen am Formkörper eines gehäuselosen, eckigen Sensors Befestigungen vorgesehen werden, um diese an ihrem Einsatzort montieren zu können. Die als Gewindeeinsätze, Gewindedurchführungen oder Gewindepfosten ausgeführten Befestigungen müssen ebenfalls vor dem Spritzgießen in der jeweiligen Form platziert und fixiert werden.

Ein Verfahren nach dem Oberbegriff von Anspruch 1 wird in US 5 113 466 gezeigt.

Der Erfindung liegt daher die Aufgabe zugrunde, einen Sensor bereitzustellen, der insbesondere in kleinen Stückzahlen mit geringen Herstellungskosten produziert werden kann und für den Kunden einen zusätzlichen Montagenutzen bietet.

Die Lösung dieser Aufgabe ist durch den Gegenstand gemäß dem unabhängigen Verfahrensanspruch und dem nebengeordneten Vorrichtungsanspruch gegeben.

Bevorzugte und/oder vorteilhafte Ausführungen und Weiterbildungen sind Gegenstand der jeweiligen Unteransprüche.

Die vorliegende Erfindung umfasst ein Herstellungsverfahren nach Anspruch 1 für einen Sensor, wobei durch zumindest teilweises Umspritzen von einer Anzahl von Bauelementen mit einer Kunststoffmasse ein Formkörper, beispielsweise mit eckiger Form gebildet wird, dessen Außenabmessungen den Innenabmessungen einer Spritzgussform entsprechen. Als Bauelemente können allgemein alle optischen, elektronischen, mechanischen und/oder hybridintegrierten Bauelemente verstanden werden, die für die Funktion und Handhabbarkeit bzw. Montage eines jeweiligen Sensors erforderlich sind. Insbesondere ist ein für die jeweilige Messaufgabe ausgebildeter Messwertaufnehmer von diesen Bauelementen umfasst. In einem ersten Schritt werden die optischen, elektronischen und/oder mechanischen Bauelemente des Sensors auf einer Oberseite und/oder Rückseite einer Leiterplatte mechanisch fixiert. In einem weiteren Schritt wird die bestückte Leiterplatte in die Spritzgussform eingelegt. In der Spritzgussform wird die Leiterplatte mittels Auflagefingern in einer definierten Lage zur Wandung der Spritzgussform gehalten. Anschließend wird die Kunststoffmasse im flüssigen Zustand in die Spritzgussform gespritzt, so dass die Leiterplatte mit den Bauelementen in dieser fixierten Lage wenigstens teilweise umspritzt werden.

Ein Messwertaufnehmer wird bevorzugt als ein hybridintegriertes Bauelement ausgeführt, das seinerseits entsprechend einer jeweiligen Messaufgabe eine Anzahl elektronischer, mechanischer und/oder optischer Bauelemente umfasst, und bezüglich der Leiterplattenmontage somit ein einzelnes vorgefertigtes Bauelement bildet.

Gegebenenfalls kann es wünschenswert sein, dass der Messwertaufnehmer nicht von der Kunststoffmasse überdeckt, beziehungsweise nicht vollständig in der Kunststoffmasse eingebettet wird. Dies kann beispielsweise bei optischen Sensoren der Fall sein, wenn der Strahlengang bis zum optischen Sensor nicht durch die Vergussmasse erfolgen soll. Hierzu ist in Weiterbildung der Erfindung vorgesehen, ein Schachtelement in die Kunststoffmasse einzubetten, welches einen Schacht in der Kunststoffmasse bildet. Der Messwertaufnehmer ist dabei im Schacht angeordnet. Das Schachtelement wird vor dem Umspritzen mit der Kunststoffmasse auf der Platine befestigt, so dass in Aufsicht auf die Platine betrachtet die Schachtwandung den Messwertaufnehmer umgibt. Beim Einspritzen des Kunststoffs dringt die Kunststoffmasse nicht oder zumindest nicht vollständig in das Schachtinnere ein, so dass der Schacht frei von der Kunststoffmasse bleibt, beziehungsweise, so dass nach dem Einspritzen die Kunststoffmasse einen durch das Schachtelement gebildeten Schacht umgibt. Dazu ist es im allgemeinen günstig, das Schachtelement dichtend auf der Platine zu befestigen, so dass ein Eindringen der Kunststoffmasse beim Umspritzen zwischen dem zur Platine weisenden Ende des Schachtelements und der Platine verhindert wird. Im Schacht können dann auch weitere Elemente angeordnet sein. Beispielsweise kann der Schacht zur Abdichtung mit einem Fenster aus geeignetem Material oder einem optischen Element verschlossen sein.

In einer anderen, ebenfalls bevorzugten Ausführungsform oder Weiterbildung der Erfindung kann ein Messwertaufnehmer eines optischen Sensors ein auf der Leiterplatte mechanisch fixiertes optoelektronisches Bauelement sowie eine vormontierte Linseneinheit mit einem Linsenträger und wenigstens eine Linse umfassen. Der Linsenträger kann in eine Nut der Leiterplatte eingelegt und in der Spritzgussform und zumindest teilweise umspritzt werden. Hier bildet der Linsenträger vorzugsweise einen wie oben erwähnten Schacht in der Kunststoffmasse.

Dieser zwei bzw. mehrteilige Aufbau eines optischen Messwertaufnehmers ermöglicht die Verwendung eines optoelektronischen Standardbauelements z.B. einer Fotodiode und einer anwendungsspezifischen Optik, so dass auf ein spezielles, vorgefertigtes, hybridintegriertes Bauelement verzichtet werden kann.

Durch das Anpressen des Linsenträgers während des Spritzgießens wird verhindert, dass die noch flüssige Kunststoffmasse zwischen die Leiterplatte bzw. zwischen das optoelektronische Bauelement und der Optik eindringen kann und somit den optischen Strahlengang des Messwertaufnehmers behindert. Der Linsenträger wird bevorzugt nur mit seinen senkrecht zur Leiterplatte stehenden Seiten umspritzt, so dass die äußere, dem optoelektronischen Bauelement abgewandet Seite des Linsenträgers mit dem Kunststoffformkörper des Sensors im wesentlichen bündig abschließen kann.

Im Vergleich zum Stand der Technik ermöglicht das erfindungsgemäße Verfahren einen "gehäuselosen", beispielsweise eckigen Sensor zu fertigen, wobei eine in der Regel ohnehin für die Primärelektronik notwendige Leiterplatte gleichzeitig als Chassis, d.h. als Montageplattform, für den mechanischen Sensoraufbau mitbenutzt werden kann.

Die mechanischen Bauelemente umfassen erfindungsgemäß nach Anspruch 1 wenigstens ein Befestigungselement, das für die Befestigung des Sensors vorgesehen ist. Als ein solche Befestigungselement kann ein Gewindeeinsatz oder ein Gewindehülse in die Leiterplatte eingeklippt werden, der oder die vollständig oder zumindest teilweise mit der Kunststoffmasse im Spritzgussverfahren umspritzt werden. Somit entsteht eine kraft- und formschlüssige Verbindung zwischen dem Befestigungselement und dem Formkörper eines Sensors, wodurch die bei einer Montage des Sensors auftretenden Kräfte optimal im Formkörper verteilt aufgenommen werden.

Besonders vorteilhaft ist, dass die elektronischen und die mechanischen Bauelemente mit einer in der Elektronik üblichen Bestückungstechnik auf der Leiterplatte platziert werden können, und mit üblichen Befestigungsverfahren, wie einklippen, kleben und/oder löten, auf der Leiterplatte fixiert werden können. Ein Sensorchassis kann somit in einem herkömmlichen Bestückungsautomat mit den allen Bauelementen bestückt werden.

In einer besonders vorteilhaften Weiterbildung der Erfindung kann auch ein Leiterplattennutzen, der eine Anzahl in der Regel identischer Leiterplatten umfasst, die in der Spritzgussform zeitgleich im Nutzen mit der Kunststoffmasse umspritzt werden. Mit einem kompletten oder auch halben Leiterplattennutzen als Montageplattform kann eine entsprechende Anzahl von Sensoren gleichzeitig mit einem beispielsweise eckigen Spritzgussgehäuse versehen werden. Die einzelnen Sensoren werden anschließend aus dem Leiterplattennutzen herausgetrennt.

Eine weitere Ausgestaltung der Erfindung sieht vor, das die bestückte Leiterplatte eines jeweiligen Sensors mit einer transparenten oder halbtransparenten Kunststoffmasse umspritzt werden. Dadurch wird es ermöglicht, die Beschriftung des Sensors, z.B. Typen und/oder Anschlussbezeichnungen direkt auf der Leiterplatte aufzubringen, die durch den durchsichtigen Formkörper des Sensors sichtbar bleibt. Somit kann besonders vorteilhaft ein zusätzlicher Beschriftungsaufdruck auf der Oberfläche des Formkörpers eingespart werden.

Die Erfindung umfasst ebenfalls einen gehäuselosen, beispielsweise eckigen Sensor nach Anspruch 8, der mit dem erfindungsgemäßen Verfahren herstellbar wäre. Ein solcher Sensor umfasst eine Leiterplatte, auf dessen Oberseite und/oder Rückseite mechanische und elektronische Bauelemente montiert sind, wobei Leiterplatte und die mechanischen Bauelemente von einem Formkörper aus Kunststoff zumindest teilweise umgeben sind, wobei der Formkörper in Weiterbildung der Erfindung beispielsweise eine eckige Form aufweisen kann. Alle Bauelemente inklusive dem Messgrößenaufnehmer, der z.B. bei einem induktiven Näherungssensor als Spule ausgeführt ist, sind somit direkt auf der ebenen Leiterplatte angeordnet.

Auf der Leiterplatte ist unter den mechanischen Bauelementen wenigstens ein Befestigungselement für die Befestigung des Sensors vorgesehen, das als Gewindeeinsatz ausgeführt sein kann.

Viele Sensorbauformen, insbesondere auch eckige Formen sollen in der Regel wenigstens zwei Schraubverbindungen, mit denen ein jeweiliges Sensorgehäuse an einem Maschinen oder Anlagenteil befestigt wird, aufweisen. Bevorzugter Weise sind an einer Montage-/Rückseite des Formkörpers eines erfindungsgemäßen Sensors zusätzliche Passstifte vorgesehen, die zur exakten Positionierung des Sensors dienen, so dass eine zweite Schraubverbindung zur Montage verzichtbar ist. Somit ist Anwenderseitig nur noch eine Bohrung an einer Maschine bzw. Anlage notwendig. Die Passstifte sind bevorzugter Weise leicht entfernbar ausgeführt, so dass sie bei der Montage abgebrochen oder abgeschnitten werden können.

Alternativ zum Gewindeeinsatz kann der Sensor rückseitig mit einer Gewindehülse ausgeführt sein, die gleichzeitig als Sensorbefestigung und zur Durchführung der elektrischen Anschlüsse einsetzbar ist. Somit ist der Sensoranschluss besonders vorteilhaft in einen geschützten Maschinen- bzw. Anlagenteil überführbar.

In einer bevorzugten Ausführungsform ist der Formkörper des Sensors aus einem transparenten oder halbtransparenten Kunststoff ausgeführt. Dadurch ist eine Sensorbeschriftung auf der Leiterplatte möglich und muss nicht extra auf der Oberfläche des Formkörpers aufgebracht werden. Zusätzlich kann eine Leuchtdiode oder ein anderes Anzeigeelement auf der Leiterplatte angeordnet sein, welches als Funktionsanzeige für den Sensor dient. Das Anzeigeelement ist bei der Sensorfertigung maschinell bestückbar und ohne zusätzliche Komponenten, wie Lichtleiter oder transparente Abdeckfolien in einem großen Winkel durch den transparenten bzw. halbtransparenten Formkörper des Sensors sichtbar.

Diese und weitere Merkmale sowie weitere damit einhergehende Vorteile der Erfindung ergeben sich aus der nachfolgenden näheren Beschreibung bevorzugter Ausführungsbeispiele unter Bezugnahme auf die beigefügte Zeichnungen. In den Zeichnungen zeigen:
- Fig. 1:: einen gehäuselosen, induktiven Näherungssensor, mit einem eckigen Gehäuse und einem eingegossenen Gewindeeinsatz.
- Fig. 2:: einen gehäuselosen, induktiven Näherungssensor, mit einem eckigen Gehäuse und einer rückseitig angeordneten Gewindehülse.
- Fig. 3:: einen gehäuselosen, optischen Näherungssensor, mit einem eckigen Gehäuse und einem optischen Messwertaufnehmer.

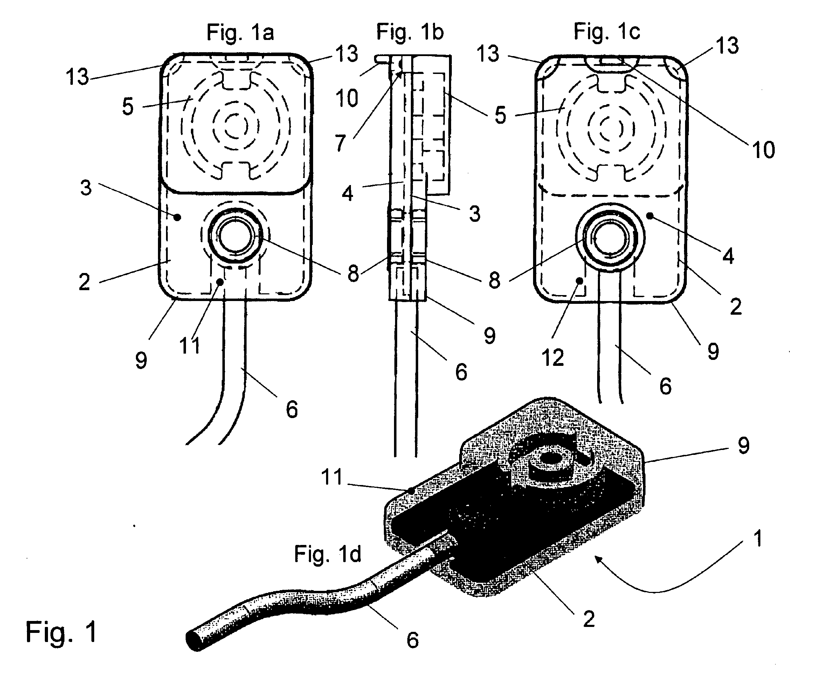

Die Figur 1 zeigt einen induktiven Näherungssensor in einer eckigen Sensorbauform mit einem Gewindeeinsatz, der zur Befestigung des Sensors an einem vorgesehenen Einsatzort dient. Anstelle des Gewindeeinsatzes könnte gleichermaßen eine gewindelose Durchführung für eine Schraub- oder Nietverbindung an dieser Stelle vorgesehen sein.

Der Sensor 1 umfasst eine Leiterplatte 2, die manuell oder in bevorzugter Weise mit einem Bestückungsautomaten bestückt worden ist, wobei die Bauelementen sowohl auf der Oberseite 3, als auch auf der Rückseite 4 der Leiterplatte 2 platziert sein können. Die Oberflächen der Leiterplatte sind mit üblichen Leiterbahnen für die Kontaktierung eines Messwertaufnehmers 5, der im vorliegenden Beispiel im Wesentlichen eine Spule umfasst, des Anschlusskabels 6 und der Leuchtdiode 7 vorgesehen, die in der vorliegenden Zeichnung nicht explizit dargestellt sind.

Neben den üblichen Kontaktlöchern einer Leiterplatte, die zur Kontaktierung von Spule 5 und Anschlusskabels 6 verwendbar sind, enthält die Leiterplatte zusätzliche Montageöffnungen, durch die bzw. in denen die verschiedenen Bauelemente mit einer Spreiznietverbindung durchführbar bzw. zu befestigen sind. Die betreffenden Bauelemente können zusätzlich oder alternativ durch Klebe- und/oder Lötverbindungen auf der Leiterplatte befestigt werden.

Ein Gewindeeinsatz 8 ist durch eine Öffnung in der Leiterplatte geführt und dient zur späteren Aufnahme einer Befestigungsschraube bei der Montage des Sensors. Der Gewindeeinsatz kann einteilig oder zweiteilig ausgeführt sein und in die Leiterplatte eingeklippt, aufgenietet, aufgeklebt und/oder aufgelötet sein. Des Weiteren kann an dem Gewindeeinsatz 8 eine im Detail nicht dargestellte Zugentlastung für das Anschlusskabel 6 integriert sein. Gegebenenfalls kann das Anschlusskabel 6 auch über eine zusätzliche Klemmvorrichtung an der Leiterplatte fixiert sein, die in der Zeichnung ebenfalls nicht gezeigt ist.

Die Leiterplatte ist von einem Formkörper 9 aus Kunststoff umschlossen, das in einem Spritzgussverfahren herstellbar ist. Das Anschlusskabel 6 ist dabei durch eine Stirnseite aus dem im Wesentlichen quaderförmigen Formkörper 9 herausgeführt.

Die Oberseite 11 des Formkörpers 9 weist im Bereich der hoch aufbauenden Spule 5 einen größeren Abstand zur Leiterplatte auf, um die Spule vollständig zu umschließen. Der Gewindeeinsatz 8 schließt bündig mit den Oberflächen auf Oberseite 11 und Unterseite 12 des Formkörpers 9 ab.

Auf der Rückseite 12 des Formkörpers 9 ist ein zusätzlicher Passstift 10 vorgesehen, der zur exakten Positionierung des Sensors bei seiner Montage verwendet werden kann. Der Passstift 10 ist derart gestaltet, dass dieser durch Abbrechen oder Abschneiden leicht entfernbar ist, sofern dieser nicht benötigt wird.

Der Formkörper 9 weist auf seiner Oberseite 11 sowie auf seiner Unterseite 12 Vertiefungen 13, in denen die Leiterplatte 2 während des Spritzgießens von Aufnahmefinger der Spritzgussform gehalten worden ist.

Eine auf der Rückseite der Leiterplatte vorgesehene Leuchtdiode 7, ist durch einen transparenten oder halbtransparenten Formkörper des Sensors auch von der Oberseite gut sichtbar.

Neben der Spule für einen induktiven Näherungssensors, kann ein in der Figur dargestellter Sensor auch eine Elektrodenanordnung als Messwertaufnehmer 5 umfassen, mit dem z.B. kapazitive Näherungssensoren realisiert werden.

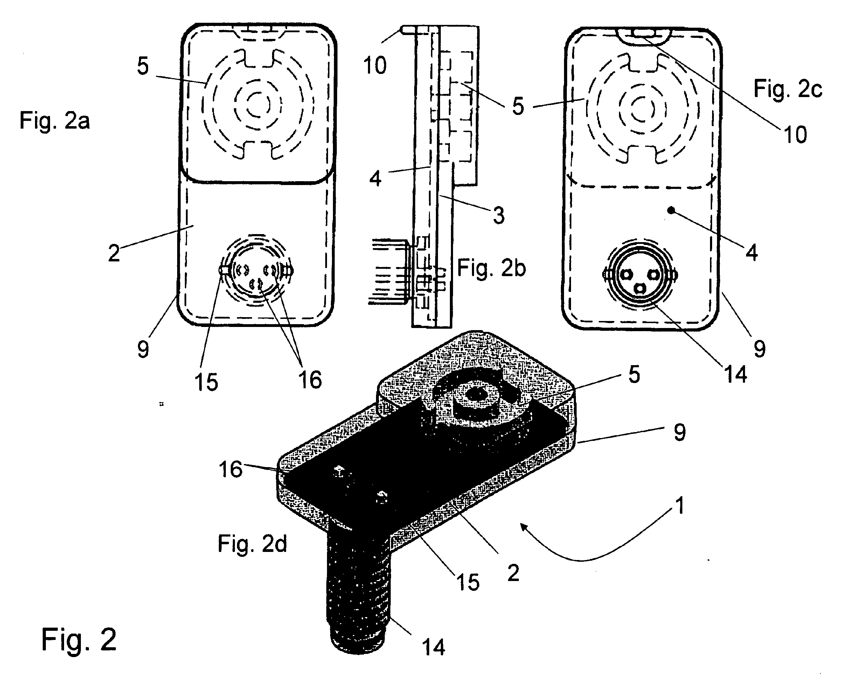

Die Figur 2 zeigt eine weitere Ausführungsform eines induktiven Näherungssensor dargestellt, wobei der grundsätzliche Aufbau im Wesentlichen zu dem zuvor beschriebenen Sensor identisch ist.

Der wesentliche Unterschied besteht in der Vorrichtung zur Befestigung des Sensors, die in dem vorliegenden Fall als eine Befestigungshülse 14 auf der Unterseite 12 des Formkörpers 9 vorgesehen ist.

Die Befestigungshülse 14 ist mit zwei Verriegelungszapfen 15 versehen, die durch entsprechende Öffnungen von der Rückseite 4 durch die Leiterplatte 2 geführt sind. Der elektrische Anschluss des Sensors ist bevorzugt über die Befestigungshülse 14 bereitzustellen, wobei beispielsweise ein Anschlusskabel durch das Innere der Befestigungshülse 14 geführt ist. Alternativ kann in der Befestigungshülse 14 auch ein Steckkontakt vorgesehen sein. Die elektrischen Verbindungen mit den im weiteren nicht dargestellten Leiterbahnen auf der Oberseite 3 der Leiterplatte 2 werden durch Kontaktbeine 16 bereitgestellt, die durch entsprechende Kontaktlöcher von der Rückseite 4 durch die Leiterplatte geführt und auf der Oberseite 3 mit den Leiterbahnen verlötet sind.

Diese Ausführung ist besonders vorteilhaft, um den Sensoranschluss durch eine Gehäusewand in einen geschützten Maschinenteil zu überführen.

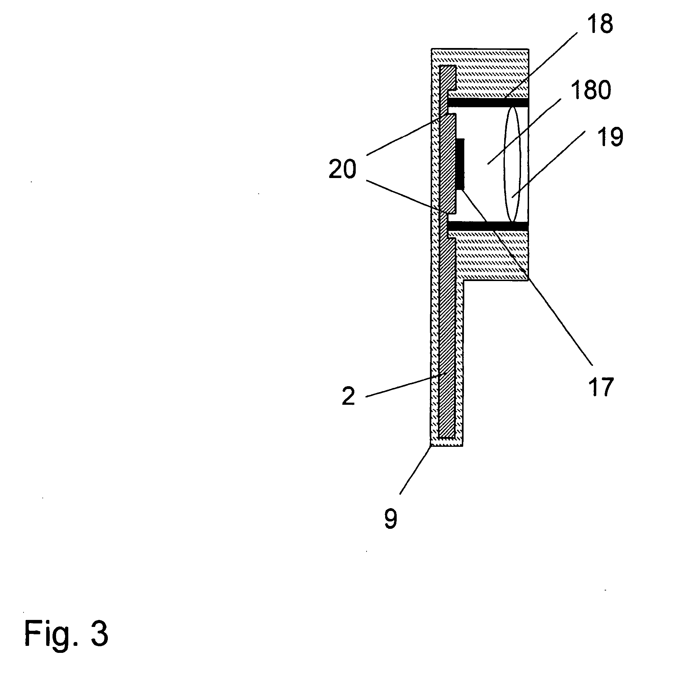

In der Figur 3 ist eine weitere Ausführungsform der vorliegenden Erfindung dargestellt und zeigt einen optischen Sensor.
Der Sensor 1 umfasst wiederum eine Leiterplatte 2, die mit dem Messwertaufnehmer 5 und weiteren mechanischen und elektronischen bestückt worden ist, die im Einzelnen nicht wiederholt dargestellt worden sind. Zur Befestigung eines solchen Sensors kommen, wie in den Figuren 1 und 2 dargestellt, sowohl die Gewindeeinsätze 8 als auch die Befestigungshülsen 14 in betracht.

Der Messwertaufnehmer 5 umfasst z.B. eine Fotodiode 17 oder ein anderes optoelektronisches Bauelement, das auf der Leiterplatte 2 aufgelötet ist. Die elektrische Kontaktierung der Fotodiode 17 erfolgt bevorzugt über die Rückseite 4 der Leiterplatte 2, wobei in der Zeichnung nicht dargestellte, für den Fachmann der Leiterplattentechnik bekannte Durchkontaktierungen verwendet werden.

Der Messwertaufnehmer umfasst zusätzlich eine Linseneinheit, die einem Linsenträger 18 und wenigstens eine Linse 19 enthält. Der Linsenträger hat die Gestalt eines Rohres, welches nach dem Einspritzen des Kunststoffs in die eingebettet ist und einen Schacht 180 in der Kunststoffmasse definiert, dessen innenseitige Schachtwandung den Messwertaufnehmer umgibt. Die Linseneinheit stellt somit ein vorgefertigtes optisches Bauelement dar, dass vor dem Spritzgießen in einer Nut 20 auf der Leiterplatte 2, über der Fotodiode 17 platziert wird.

Die Nut 20 gewährleistet mit entsprechenden Auflagepunkten in dem nicht dargestellten Spritzgusswerkzeug eine mechanisch ausreichende Fixierung der Linseneinheit. Durch einen geeigneten Anpressdruck wird eine hinreichende Abdichtung gewährleistet und somit ein Durchdringen der Kunststoffmasse zwischen Leiterplatte 2 und Linsenträger 18 unterdrückt.

## Patentansprüche

1. Verfahren zum Herstellen wenigstens eines Sensors, wobei durch zumindest teilweises Umspritzen einer Anzahl von Bauelementen, die optische, elektronische, mechanische und/oder hybride Bauelemente, jedoch wenigstens einen Messwertaufnehmer umfassen, mit einer Kunststoffmasse ein vorzugsweise eckiger Formkörper gebildet wird, dessen Außenabmessungen den Innenabmessungen einer Spritzgussform entsprechen,
**dadurch gekennzeichnet, dass**
- die Bauelemente (5-8, 14, 17-19) vor dem Umspritzen auf einer Oberseite (3) und/oder Rückseite (4) wenigstens einer Leiterplatte (2) mechanisch fixiert werden,
- wobei die wenigstens eine mit den Bauelementen bestückte Leiterplatte in die Spritzgussform eingelegt wird,
- dort mittels Auflagefingem in einer definierten Lage zur Wandung der Spritzgussform gehalten wird,
- die wenigstens eine Leiterplatte mit den Bauelementen in dieser fixierten Lage umspritzt wird und
- die mechanischen Bauelemente wenigstens ein Befestigungselement (8, 14) für die Befestigung des Sensors (1) umfassen, das zumindest teilweise umspritzt wird, so dass eine mechanisch feste Verbindung mit dem Formkörper (9) gebildet wird.

2. Verfahren nach Anspruch 1, **dadurch gekennzeichnet, dass** die Bauelemente auf die Leiterplatte eingelegt, eingepresst, eingeklippt, geklebt und/oder gelötet werden.

3. Verfahren nach einem der vorstehenden Ansprüche, **dadurch gekennzeichnet, dass** als Messwertaufnehmer ein vormontiertes, hybridintegriertes Bauelement auf der Leiterplatte mechanisch fixiert wird, das optische, elektronische und/oder mechanische Bauelemente umfasst und zumindest teilweise umspritzt wird.

4. Verfahren nach einem der vorstehenden Ansprüche, bei welchem ein Schachtelement vor dem Umspritzen mit der Kunststoffmasse auf der Platine befestigt wird, so dass in Aufsicht auf die Platine betrachtet die Schachtwandung den Messwertaufnehmer umgibt, so dass nach dem Einspritzen die Kunststoffmasse einen durch das Schachtelement gebildeten Schacht umgibt.

5. Verfahren nach einem der vorstehenden Ansprüche, **dadurch gekennzeichnet, dass** als Messwertaufnehmer ein auf der Leiterplatte mechanisch fixiertes optoelektronisches Bauelement sowie eine vormontierte Linseneinheit mit einem Linsenträger und wenigstens eine Linse umfasst, wobei der Linsenträger in eine Nut der Leiterplatte eingelegt und in der Spritzgussform und zumindest teilweise umspritzt wird.

6. Verfahren nach einem der vorstehenden Ansprüche, **dadurch gekennzeichnet, dass** die Leiterplatte mit einer Anzahl identischer Leiterplatten zu einem Leiterplattennutzen zusammengefasst wird, die Leiterplatten im Leiterplattennutzen in die Spritzgussform eingelegt und umspritzt werden, und nach dem Spritzgießen die umgossenen Leiterplatten aus dem Leiterplattennutzen getrennt werden.

7. Verfahren nach einem der vorstehenden Ansprüche, **dadurch gekennzeichnet, dass** als Kunststoffmasse ein transparenter oder halbtransparenter Kunststoff verwendet wird.

8. Sensor umfassend wenigstens eine Leiterplatte (2) auf dessen Oberseite (3) und/oder Rückseite (4) wenigstens ein optisches, mechanisches, elektronisches und/oder hybridintegriertes Bauelement (5-8, 14, 17-19) montiert ist, wobei die wenigstens eine Leiterplatte und die Bauelemente von einem Formkörper (9) aus Kunststoff zumindest teilweise umgeben sind und dass wenigstens ein mechanisches Bauelement auf der Leiterplatte als Befestigungselement (8, 14) für die Befestigung des Sensors (1) ausgeführt ist.

9. Sensor nach Anspruch 8, **dadurch gekennzeichnet, dass** das Befestigungselement einen Gewindeeinsatz oder eine Gewindehülse umfasst.

10. Sensor nach vorstehendem Anspruch, **dadurch gekennzeichnet, dass** ein elektrischer Anschluss durch die Gewindehülse geführt ist.

11. Sensor nach einem der Ansprüche 8 bis 10, **dadurch gekennzeichnet, dass** zusätzliche Passstifte an dem Formkörper zur exakten Positionierung des Sensors vorgesehen sind.

12. Sensor nach einem der Ansprüche 8 bis 11, **dadurch gekennzeichnet, dass** die Bauelemente wenigsten einen Messwertaufnehmer umfassen, der als elektronisches, mechanisches und/oder hybridintegriertes Bauelement ausgeführt ist.

13. Sensor nach einem der Ansprüche 8 bis 12, **dadurch gekennzeichnet, dass** ein in die Kunststoffmasse eingebettetes Schachtelement vorgesehen ist, welches einen Schacht in der Kunststoffmasse bildet, und wobei der Messwertaufnehmer im Schacht angeordnet ist.

14. Sensor nach einem der Ansprüche 8 bis 13, **dadurch gekennzeichnet, dass** die Bauelemente einen optischen Messwertaufnehmer mit einem optoelektronischen Bauelement sowie einer, sich darüber erstreckenden Linseneinheit mit einem Linsenträger und wenigstens einer Linse umfassen.

15. Sensor nach einem der Ansprüche 8 bis 14, **dadurch gekennzeichnet, dass** der Formkörper aus einem transparentem oder halbtransparentem Kunststoff besteht und vorzugsweise auf der Leiterplatte eine Leuchtdiode vorgesehen ist.

## Claims

1. Process for producing at least one sensor, whereby through the at least partial extrusion coating of a number of component parts, comprising optical, electronic, mechanical and/or hybrid component parts, but at least one measuring sensor, with a plastic compound, a preferably angular molding is formed, the outside dimensions of which correspond to the inside dimensions of an injection mold, **characterized in that**
- the component parts (5-8, 14, 17-19) are mechanically fixed to a top side (3) and/or rear side (4) of at least one printed circuit board (2) before extrusion coating takes place,
- whereby the at least one printed circuit board with the component parts mounted is inserted into the injection mold,
- by means of locating fingers is held there in a defined position in relation to the walls of the injection mold,
- the at least one printed circuit board with the component parts is extrusion-coated in this fixed position, and
- the mechanical component parts comprise at least one fixing element (8, 14) for fixing the sensor (1), said element being at least partly extrusion-coated, so that a mechanically permanent connection is established with the molding (9).

2. Process in accordance with Claim 1, **characterized in that** the component parts are placed, pressed, clipped, bonded and/or soldered onto the printed circuit board.

3. Process in accordance with one of the above Claims, **characterized in that** a preassembled, hybrid-integrated component part is mechanically fixed to the printed circuit board as a measuring sensor, comprising optical, electronic and/or mechanical component parts and is at least partly extrusion-coated.

4. Process in accordance with one of the above Claims, in which a shaft element is mounted on the printed circuit board before extrusion coating with the plastic compound takes place, so that when the printed circuit board is viewed from above, the shaft walls surround the measuring sensor, so that after injection molding the plastic compound surrounds a shaft formed by the shaft element.

5. Process in accordance with one of the above Claims, **characterized in that** a measuring sensor comprises an optoelectronic component part mechanically fixed to the printed circuit board as well as a preassembled lens unit with a lens holder and at least one lens, whereby the lens holder is inserted into a groove in the printed circuit board and in the injection mold and is at least partly extrusion-coated.

6. Process in accordance with one of the above Claims, **characterized in that** the printed circuit board is combined with a number of identical printed circuit boards to form a circuit board panel, the printed circuit boards in the circuit board panel are inserted into the injection mold and are extrusion-coated, and after the injection molding the extrusion-coated printed circuit boards are removed from the circuit board panel.

7. Process in accordance with one of the above Claims, **characterized in that** a transparent or semi-transparent plastic is used as a plastic compound.

8. Sensor comprising at least one printed circuit board (2) on the top side (3) and/or rear side (4) of which at least one optical, mechanical, electronic and/or hybrid-integrated component part (5-8, 14, 17-19) is mounted, whereby the at least one printed circuit board and the component parts are at least partly surrounded by a molding (9) made of plastic and that at least one mechanical component part is embodied on the printed circuit board as a fixing element (8, 14) for fixing the sensor (1).

9. Sensor in accordance with Claim 8, **characterized in that** the fixing element comprises a threaded insert or a threaded sleeve.

10. Sensor in accordance with the above Claim, **characterized in that** an electrical connection is routed through the threaded sleeve.

11. Sensor in accordance with one of the Claims 8 to 10, **characterized in that** additional locating pins are provided for in the molding for the exact positioning of the sensor.

12. Sensor in accordance with one of the Claims 8 to 11, **characterized in that** the component parts comprise at least one measuring sensor which is embodied as an electronic, mechanical and/or hybrid-integrated component part.

13. Sensor in accordance with one of the Claims 8 to 12, **characterized in that** a shaft element embedded in the plastic compound is provided for, forming a shaft in the plastic compound, and whereby the measuring sensor is located in this shaft.

14. Sensor in accordance with one of the Claims 8 to 13, **characterized in that** the component parts comprise an optical measuring sensor with an optoelectronic component part and with a lens unit extending over it with a lens holder and at least one lens.

15. Sensor in accordance with one of the Claims 8 to 14, **characterized in that** the molding consists of a transparent or semi-transparent plastic and that preferably a light-emitting diode is provided for on the printed circuit board.

## Revendications

1. Procédé permettant de fabriquer au moins un détecteur, dans lequel par l'extrusion au moins partielle d'un certain nombre de composants qui comprennent des composants optiques, électroniques, mécaniques et/ou hybrides, mais au moins un capteur de valeurs de mesure, un corps de forme de préférence angulaire est formé avec une masse de matière plastique, dont les dimensions extérieures correspondent aux dimensions intérieures d'un moule à injection, **caractérisé en ce que**
- les composants (5-8, 14, 17-19) sont fixés mécaniquement avant l'extrusion sur une face supérieure (3) et/ou une face arrière (4) d'au moins une carte de circuit imprimé (2),
- la au moins une carte de circuit imprimé pourvue des composants étant insérée dans le moule à injection,
- étant maintenue à l'intérieur au moyen de doigts d'appui dans une position définie par rapport à la paroi du moule à injection,
- la au moins une carte de circuit imprimé avec les composants est extrudée dans cette position fixée et
- les composants mécaniques comprennent au moins un élément de fixation (8, 14) pour la fixation du détecteur (1), qui est extrudé au moins partiellement de sorte qu'une liaison à demeure est formée avec le corps de forme (9).

2. Procédé selon la revendication 1, **caractérisé en ce que** les composants sont posés, enfoncés, encliquetés, collés et/ou brasés sur la carte de circuit imprimé.

3. Procédé selon l'une des revendications précédentes, **caractérisé en ce que**, en tant que capteur de valeurs de mesure, un composant intégré hybride pré-monté est fixé mécaniquement sur la carte de circuit imprimé, lequel comprend des composants optiques, électroniques et/ou mécaniques et est extrudé au moins partiellement.

4. Procédé selon l'une des revendications précédentes, dans lequel un élément de puits est fixé sur la platine avant l'extrusion avec la masse de matière plastique, de sorte que, vu de la platine, la paroi du puits entoure le capteur de valeurs de mesure, afin qu'après l'extrusion, la masse de matière plastique entoure un puits formé par l'élément de puits.

5. Procédé selon l'une des revendications précédentes, **caractérisé en ce que**, en tant que capteur de valeurs de mesure, un composant opto-électronique fixé mécaniquement sur la carte de circuit imprimé comprend une unité de lentilles pré-montée avec un support de lentilles et au moins une lentille, le support de lentilles étant inséré dans une rainure de la carte de circuit imprimé et étant extrudé dans le moule à injection au moins partiellement.

6. Procédé selon l'une des revendications précédentes **caractérisé en ce que** la carte de circuit imprimé est associée à un certain nombre de cartes de circuit imprimé identiques sur un flan de carte de circuit imprimé, les cartes de circuit imprimé sont déposées dans le flan de carte de circuit imprimé dans le moule à injection, et, après le moulage par injection, les cartes de circuit imprimé coulées sont séparées du flan de carte de circuit imprimé.

7. Procédé selon l'une des revendications précédentes, **caractérisé en ce qu'**une matière plastique transparente ou semi-transparente est utilisée comme masse de matière plastique.

8. Détecteur comprenant au moins une carte de circuit imprimé (2) sur la face supérieure (3) et/ou la face arrière (4) de laquelle au moins un composant optique, mécanique, électronique et/ou intégré hybride (5-8, 14, 17-19) est monté, la au moins une carte de circuit imprimé et les composants étant entourés au moins partiellement par un corps de forme (9) en matière plastique et au moins un composant mécanique sur la carte de circuit imprimé étant réalisé en tant qu'élément de fixation (8, 14) pour la fixation du détecteur (1).

9. Détecteur selon la revendication 8, **caractérisé en ce que** l'élément de fixation comprend une douille taraudée ou une douille filetée.

10. Détecteur selon la revendication précédente, **caractérisé en ce qu'**un raccordement électrique est réalisé par le biais de la douille filetée.

11. Détecteur selon l'une des revendications 8 à 10, **caractérisé en ce que** des goupilles de serrage supplémentaires sont prévues sur le corps de forme pour un positionnement exact du détecteur.

12. Détecteur selon l'une des revendications 8 à 11, **caractérisé en ce que** les composants comprennent au moins un capteur de valeurs de mesure qui est réalisé en tant que composant électronique, mécanique et/ou intégré hybride.

13. Détecteur selon l'une des revendications 8 à 12, **caractérisé en ce qu'**un élément de puits enrobé dans la masse de matière plastique est prévu, lequel forme un puits dans la masse de matière plastique, et le capteur de valeurs de mesure étant disposé dans le puits.

14. Détecteur selon l'une des revendications 8 à 13, **caractérisé en ce que** les composants comprennent un capteur de valeurs de mesure optique avec un composant opto-électronique ainsi qu'une unité de lentilles s'étendant au-dessus avec un support de lentilles et au moins une lentille.

15. Détecteur selon l'une des revendications 8 à 14, **caractérisé en ce que** le corps de forme est composé d'une matière plastique transparente ou semi-transparente et **en ce que**, de préférence, une diode électroluminescente est prévue sur la carte de circuit imprimé.
